(19) Europäisches Patentamt
European Patent Office
Office européen des brevets

(11) **EP 3 041 061 A1**

(12) **EUROPEAN PATENT APPLICATION**

(43) Date of publication:
06.07.2016 Bulletin 2016/27

(51) Int Cl.:
***H01L 51/52*** *(2006.01)*

(21) Application number: 15201429.6

(22) Date of filing: 18.12.2015

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: 02.01.2015 KR 20150000162

(71) Applicant: **Samsung Display Co., Ltd. Gyeonggi-do 17113 (KR)**

(72) Inventor: **JEONG, Heeseong 07638 Seoul (KR)**

(74) Representative: **Taor, Simon Edward William et al Venner Shipley LLP 200 Aldersgate London EC1A 4HD (GB)**

(54) **ORGANIC LIGHT EMITTING DIODE DISPLAY DEVICE**

(57)    An organic light emitting diode (OLED) display device includes: a substrate; a first electrode on the substrate; a light emitting layer on the first electrode; an auxiliary light emitting layer on the light emitting layer; a second electrode on the auxiliary light emitting layer; and a resonance inducing layer on the second electrode. The resonance inducing layer may include a first low-refractive-index layer and a first high-refractive-index layer. The auxiliary light emitting layer has an optical distance in a range of about 30 nm to about 63 nm. The first low-re-fractive-index layer and the first high-refractive-index layer of the resonance inducing layer each has a thickness in a range of about 5 nm to about 150 nm

FIG. 2

**Description**

Embodiments relate to an organic light emitting diode (OLED) display device, and more particularly, to an OLED display device enhanced in light efficiency by efficiently extracting light generated in a light emitting layer.

An organic light emitting diode device is a self-emission type display device that displays an image with an organic light emitting diode (OLED) that emits light. The organic light emitting diode device may not require a separate light source, unlike a liquid crystal display (LCD), and, thus, may have relatively reduced thickness and weight. Further, the organic light emitting diode device may exhibit excellent properties, e.g., low power consumption, high luminance, and high speed of response, and, thus, has drawn attention as a display device of the next generation.

The OLED may generally include a hole injection electrode, an organic light emitting layer, and an electron injection electrode. A hole injected from the hole injection electrode and an electron injected from the electron injection electrode are combined with each other to form an exciton. The OLED emits light by energy generated when the exciton falls from an excited state to a ground state.

Currently, research is being conducted on a method of enhancing light efficiency by efficiently extracting light generated in a light emitting layer in order to increase utility of an OLED display device.

It is to be understood that this background of the technology section is intended to provide useful background for understanding the technology and as such disclosed herein, the technology background section may include ideas, concepts or recognitions that were not part of what was known or appreciated by those skilled in the pertinent art prior to a corresponding effective filing date of subject matter disclosed herein.

According to one or more embodiments, an organic light emitting diode (OLED) display device includes: a substrate; a first electrode on the substrate; a light emitting layer on the first electrode; an auxiliary light emitting layer on the light emitting layer; a second electrode disposed on the auxiliary light emitting layer; and a resonance inducing layer on the second electrode. The resonance inducing layer may include a first low-refractive-index layer and a first high-refractive-index layer. The auxiliary light emitting layer may have an optical distance in a range of about 30 nm (300 angstroms, Å) to about 63 nm (630Å). The first low-refractive-index layer and the first high-refractive-index layer of the resonance inducing layer may each have a thickness in a range of about 5 nm (50Å) to about 150 nm (1500Å).

The auxiliary light emitting layer may be an electron transporting layer (ETL).

The first low-refractive-index layer may be on the second electrode, and the first high-refractive-index layer may be on the first low-refractive-index layer.

The first high-refractive-index layer may have a thickness greater than a thickness of the first low-refractive-index layer.

The resonance inducing layer may further include a second low-refractive-index layer on the first high-refractive-index layer.

The second low-refractive-index layer may have a thickness different from a thickness of the first low-refractive-index layer.

The thickness of the second low-refractive-index layer may be greater than the thickness of the first low-refractive-index layer.

The first low-refractive-index layer may have a thickness in a range of about 5 nm (50Å) to about 30 nm (300Å), the first high-refractive-index layer may have a thickness in a range of about 30 nm (300Å) to about 100 nm (1000Å), and the second low-refractive-index layer may have a thickness in a range of about 5 nm (50Å) to 150 nm (1500Å).

The first and second low-refractive-index layers may have a refractive index in a range of about 1.3 to about 1.6, and the first high-refractive-index layer may have a refractive index in a range of about 1.6 to about 3.0.

The first and second low-refractive-index layers may include at least one of LiF, Liq, aluminum(III) bis(2-methyl-8-quninolinato)-4-phenylphenolate (BAlq), and $SiO_x$.

The first high-refractive-index layer may include at least one of SiON, $SiN_x$, $ZnO_x$, $ZrO_x$, and $TiO_x$.

The first high-refractive-index layer may be on the second electrode, and the first low-refractive-index layer may be on the first high-refractive-index layer.

The first low-refractive-index layer may have a thickness greater than a thickness of the first high-refractive-index layer.

The resonance inducing layer may further include a second high-refractive-index layer on the first low-refractive-index layer.

The first high-refractive-index layer may have a thickness in a range of about 5nm (50Å) to about 30 nm (300Å), the first low-refractive-index layer may have a thickness in a range of about 5 nm (50Å) to about 100 nm (1000Å), and the second high-refractive-index layer may have a thickness in a range of about 5 nm (50Å) to about 150 nm (1500Å).

The first and second high-refractive-index layers may have a refractive index in a range of about 1.6 to about 3.0, and the first low-refractive-index layer may have a refractive index in a range of about 1.3 to about 1.6.

The low-refractive-index layer may include at least one of LiF, Liq, aluminum(III) bis(2-methyl-8-quninolinato)-4-phenylphenolate(BAlq), and $SiO_x$.

The first and second high-refractive-index layers may include at least one of SiON, $SiN_x$, $ZnO_x$, $ZrO_x$, and $TiO_x$.

The OLED display device may further include an encapsulation layer on the resonance inducing layer, wherein the encapsulation layer has a structure in which an organic layer is between a plurality of stacked inorganic layers, or a structure in which an inorganic layer and an organic layer are alternately stacked.

The inorganic layer may include at least one of $SiO_x$, SiON, and $SiN_x$, and the organic layer may be a monomer.

According to an aspect of the invention, there is provided an OLED display device as set out in claim 1. Preferred features are set out in claims 2 to 15.

Features will become apparent to those of skill in the art by describing in detail exemplary embodiments with reference to the attached drawings in which:

FIG. 1 illustrates a plan view of a pixel of an organic light emitting diode (OLED) display device according to an exemplary embodiment;

FIG. 2 illustrates a cross-sectional view taken along line I-I' of FIG. 1;

FIG. 3 illustrates a schematic view of a path of light passing through a plurality of layers having different refractive indices;

FIG. 4 illustrates a schematic view of a stacked structure in an OLED display device according to an exemplary embodiment;

FIG. 5A through 5C illustrate graphs of light extraction efficiency based on an optical thickness of an electron transporting layer (ETL);

FIG. 6 illustrates a schematic view of a stacked structure in an OLED display device according to a related art;

FIG. 7 illustrates a schematic view of a stacked structure in an OLED display device according to Example 1;

FIG. 8 illustrates a graph of light extraction efficiency of FIG. 7;

FIG. 9 illustrates a schematic view of a stacked structure in an OLED display device according to Example 2;

FIG. 10 illustrates a graph of light extraction efficiency of FIG. 8;

FIG. 11 illustrates a cross-sectional view of an OLED display device according to another exemplary embodiment; and

FIG. 12 illustrates a schematic view of a stacked structure in an OLED display device according to Example 3.

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey exemplary implementations to those skilled in the art.

In the drawing figures, the dimensions of layers and regions may be exaggerated for clarity of illustration. It will also be understood that when a layer or element is referred to as being "on" another layer or substrate, it can be directly on the other layer or substrate, or intervening layers may also be present. Further, it will be understood that when a layer is referred to as being "under" another layer, it can be directly under, and one or more intervening layers may also be present. In addition, it will also be understood that when a layer is referred to as being "between" two layers, it can be the only layer between the two layers, or one or more intervening layers may also be present. Like reference numerals refer to like elements throughout.

The spatially relative terms "below", "beneath", "lower", "above", "upper", and the like, may be used herein for ease of description to describe the relations between one element or component and another element or component as illustrated in the drawings. It will be understood that the spatially relative terms are intended to encompass different orientations of the device in use or operation, in addition to the orientation depicted in the drawings. For example, in the case where a device shown in the drawing is turned over, the device positioned "below" or "beneath" another device may be placed "above" another device. Accordingly, the illustrative term "below" may include both the lower and upper positions. The device may also be oriented in the other direction, and thus the spatially relative terms may be interpreted differently depending on the orientations.

All terminologies used herein are merely used to describe embodiments and may be modified according to the relevant art and the intention of an applicant. Therefore, the terms used herein should be interpreted as having a meaning that is consistent with their meanings in the context of the present disclosure, and is not intended to limit the disclosure. As used herein, the singular forms "a," "an," and "the" are intended to include the plural forms as well, unless the context clearly indicates otherwise. It will be further understood that the terms "comprises," "comprising," "includes" and/or "including," when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms used herein (including technical and scientific terms) have the same meaning as commonly understood by those skilled in the art to which this disclosure pertains. It will be further understood that terms, such as those defined in commonly used dictionaries, should be interpreted as having a meaning that is consistent with their meaning in the context of the relevant art and will not be interpreted in an ideal or excessively formal sense unless clearly defined in the present specification.

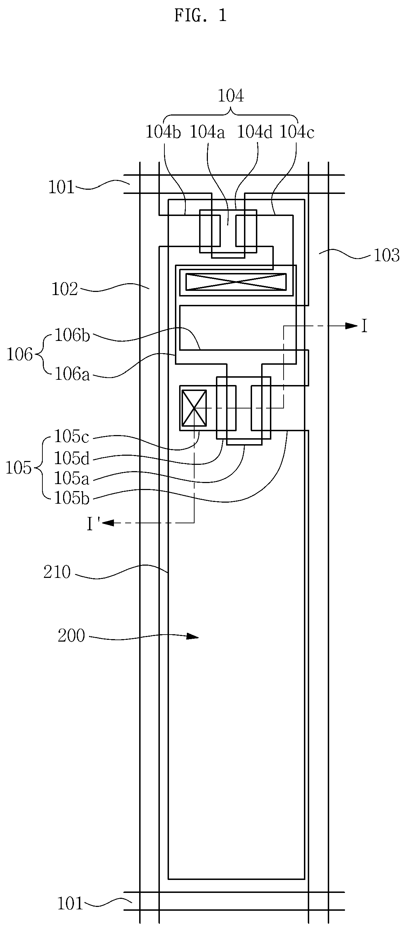

FIG. 1 illustrates a plan view of a pixel of an organic light emitting diode (OLED) display device according to an exemplary embodiment.

Referring to FIG. 1, in an OLED display device according to an exemplary embodiment, a plurality of pixel regions may be defined by a boundary among a gate line 101, a data line 102 insulated from and intersecting the gate line 101, and a common power line 103. A single pixel may be disposed in a single pixel region. However, the pixel region is not limited thereto in embodiments of the invention, e.g., a pixel region may be defined by a pixel defining layer to be described later, a plurality of pixels may be disposed in a single pixel region, and so forth.

A single pixel of the OLED display device according to the exemplary embodiment may have a 2TFT-1CAP structure. For example, the 2TFT-1CAP structure may include two thin film transistors (TFTs), i.e., a switching TFT 104 and a driving TFT 105 and a single capacitor (CAP) 106. However, the structure of the pixel of the OLED display device according to embodiments of the invention is not limited thereto, and three or more TFTs and two or more CAPs 106 may be included in a single pixel.

The switching TFT 104 may select a pixel to perform light emission. The switching TFT 104 may include a switching gate electrode 104a connected to the gate line 101, a switching source electrode 104b connected to the data line 102, a switching drain electrode 104c connected to a first capacitor plate 106a, and a switching semiconductor layer 104d.

The driving TFT 105 may apply a driving power, which allows an organic light emitting layer 233 in a pixel selected by the switching TFT 104 to emit light. The driving TFT 105 may include a driving gate electrode 105a connected to the first capacitor plate 106a, a driving source electrode 105b connected to the common power line 103, a driving drain electrode 105c connected to the first electrode 110, and a driving semiconductor layer 105d.

The CAP 106 may include the first capacitor plate 106a and a second capacitor plate 106b. The first capacitor plate 106a may be connected to the switching drain electrode 104c and the driving gate electrode 105a, and the second capacitor plate 106b may be connected to the common power line 103. Capacitance of the CAP 106 may be determined by electric charges stored in the CAP 106 and voltages between the first and second capacitor plates 106a and 106b.

A voltage having a level equivalent to a difference between a level of a data voltage transmitted by (or from) the switching TFT 104 and a level of a common voltage applied from the common power line 103 to the driving TFT 105 may be stored in the CAP 106. A current having a level corresponding to the level of the voltage stored in the CAP 106 may flow to the organic light emitting layer 233 through the driving TFT 105 to allow the organic light emitting layer 233 to emit light.

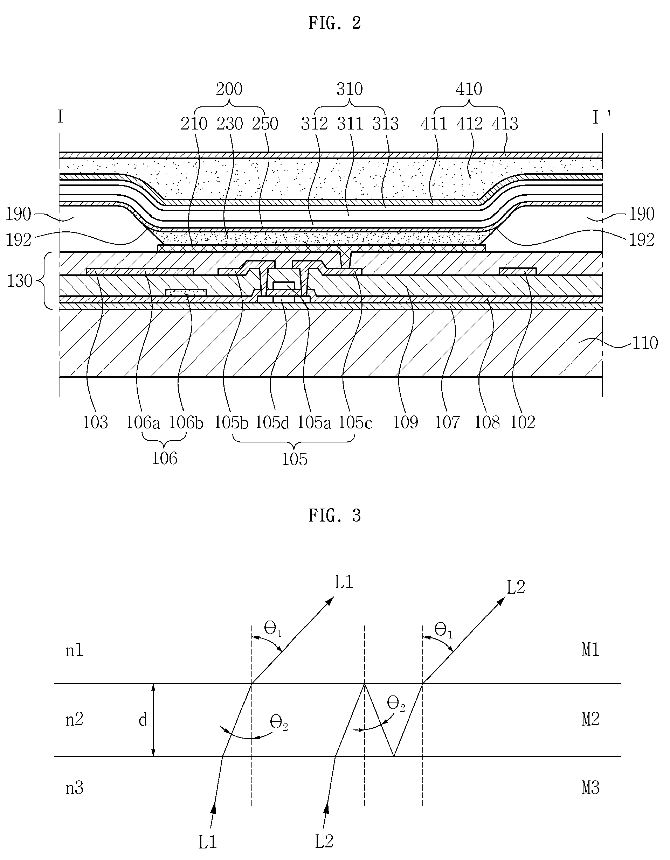

FIG. 2 illustrates a cross-sectional view taken along line I-I' of FIG. 1.

Referring to FIG. 2, the OLED display device according to the exemplary embodiment may include a first substrate 110, a driving circuit unit 130, an OLED element 200, a resonance inducing layer 310, and a thin film encapsulation layer 410.

The first substrate 110 may be an insulating substrate including at least one of glass, quartz, ceramic, plastic, and the like. However, the material forming the first substrate 110 is not limited thereto in embodiments of the invention, and may be formed of a metal material, e.g., stainless steel.

A buffer layer 107 including an inorganic or organic layer may be disposed on the first substrate 110. The buffer layer 107 may prevent or efficiently reduce infiltration of undesired components, e.g., impure elements or moisture, into the first substrate 110 and may also planarize a surface of the first substrate 110. Further, a gate insulating layer 108 may be on the first substrate 110 between the switching and driving gate electrodes 104a and 105a and the switching and driving semiconductor layers 104d and 105d, and an insulating interlayer layer 109 may be between the first and second capacitor plates 106a and 106b.

The driving circuit unit 130 may be on the buffer layer 107. The driving circuit unit 130 may include the switching TFT 104, the driving TFT 105, and the CAJP 106, and may drive the OLED element 200. As previously described with reference to FIG. 1, the OLED element 200 may display an image by emitting light based on a driving signal transmitted from the driving circuit unit 130.

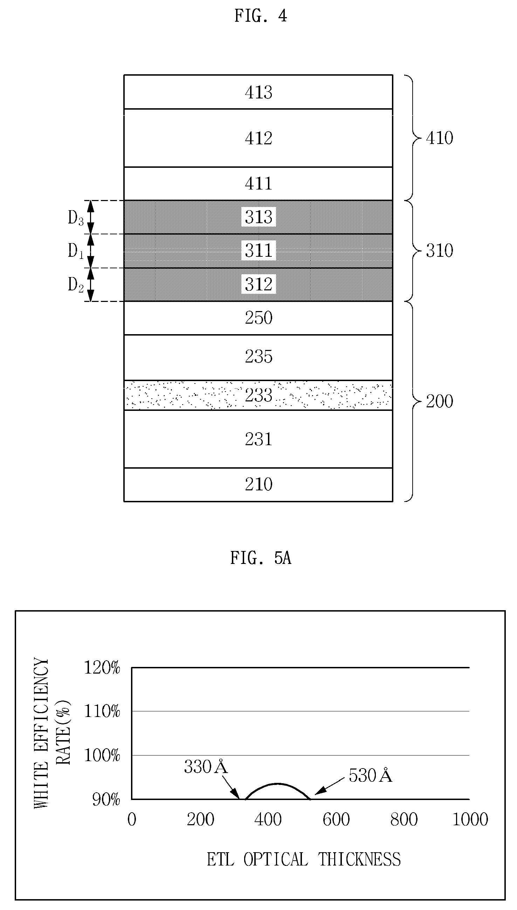

The OLED element 200 may include a first electrode 210, a light emitting element 230 on the first electrode 210, and a second electrode 250 on the light emitting element 230. The light emitting element 230 may include the organic light emitting layer 233 (refer to FIG. 4). The first electrode 210 may be an anode that injects holes and the second electrode 250 may be a cathode that injects electrons. However, the type of the first and second electrodes 210 and 250 is not limited thereto in embodiments of the invention, and the first electrode 210 may be a cathode and the second electrode 250 may be an anode.

Although not illustrated, at least one of a hole injection layer (HIL) and a hole transporting layer (HTL) may further be between the first electrode 210 and the organic light emitting layer 233, and at least one of an electron transporting layer (ETL) and an electron injection layer (EIL) may further be disposed between the organic light emitting layer 233 and the second electrode 250.

The OLED display device according to the exemplary embodiment may be a top-emission type. Accordingly, the first electrode 210 may include a reflective layer and the second electrode 250 may include a transflective layer. However, the type of the first and second electrodes 210 and 250 is not limited thereto in embodiments of the invention, and the OLED display device may be a bottom-emission type. In this case, the first electrode 210 may include a transflective layer and the second electrode 250 may include a reflective layer.

The reflective and transflective layers may include one or more of magnesium (Mg), silver (Ag), gold (Au), calcium (Ca), lithium (Li), chromium (Cr), aluminum (Al), and the like, or metal alloys thereof. Here, the type of the layer, for example, the reflective layer or the transflective layer, may be determined based on the thickness of the layer. In general, the transflective layer has a thickness of less than or equal to about 200 nanometers (nm).

The first electrode 210 may further include a transparent conductive layer and the transparent conductive layer may include transparent conductive oxide (TCO) such as indium tin oxide (ITO), indium zinc oxide (IZO), zinc oxide (ZnO), or indium oxide ($In_2O_3$).

The first electrode 210 may have a structure including a reflective layer, a double-layer structure including a reflective layer and a transparent conductive layer, or a triple-layer structure in which a transparent conductive layer, a reflective layer, and a transparent conductive layer are sequentially stacked. However, the structure of the first electrode 210 is not limited thereto in embodiments of the invention, and the first electrode 210 may have a structure including a transparent conductive layer.

The second electrode 250 may have a structure including a transparent conductive layer. In the case of being formed of a transparent conductive layer, the second electrode 250 may be an anode that injects holes and the first electrode 210 may include a reflective layer serving as a cathode.

A pixel defining layer 190 may have an aperture 192 and the first electrode 210 may be exposed through the aperture 192. In other words, the first electrode 210, the light emitting element 230, and the second electrode 250 may be sequentially stacked within the aperture 192 of the pixel defining layer 190, and the aperture 192 may define a light emission region. Further, the light emitting element 230 and the second electrode 250 may be on the pixel defining layer 190.

The resonance inducing layer 310 may be on the second electrode 250, and may include a high-refractive-index layer 311, a first low-refractive-index layer 312, and a second low-refractive-index layer 313. The resonance inducing layer 310 may assist in efficient external emission of light generated in the organic light emitting layer 233.

Details pertaining to the resonance inducing layer 310 will be described later with reference to FIG. 4.

The OLED display device according to the exemplary embodiment may further include the thin film encapsulation layer 410 on the resonance inducing layer 310. The thin film encapsulation layer 410 may protect the first electrode 210, the light emitting element 230, the second electrode 250, and the resonance inducing layer 310, and may have a structure in which at least an inorganic layer and at least an organic layer are alternately stacked.

The thin film encapsulation layer 410 may have a structure in which an organic layer and an inorganic layer are stacked, or may have a structure in which an inorganic layer and an organic layer are stacked. Although FIG. 2 illustrates the thin film encapsulation layer 410 as having a triple-layer structure of an inorganic layer 411, an organic layer 412, and an inorganic layer 413, the structure of the thin film encapsulation layer 410 is not limited thereto in embodiments of the invention, and the thin film encapsulation layer 410 may have a multilayer structure including two or more layers.

Referring to FIG. 2, the thin film encapsulation layer 410 having the structure in which the inorganic layer 411, the organic layer 412, and the inorganic layer 413 are stacked may be formed on the resonance inducing layer 310. In this case, the inorganic layers 411 and 413 may prevent or efficiently reduce infiltration of moisture or oxygen into the light emitting element 230 and the organic layer 412 may planarize a surface of the resonance inducing layer 310.

When the OLED device is a top-emission type, light generated in the organic light emitting layer 233 may be emitted outwardly through the second electrode 250, the resonance inducing layer 310, and the thin film encapsulation layer 410.

Light generated in the organic light emitting layer 233 may pass through an interlayer interface when travelling outwards; in this case, light may not pass through the interlayer interface or may be reflected therefrom. In detail, light generated in the organic light emitting layer 233 may pass through an interface between the organic light emitting layer 233 and the second electrode 250, an interface between the second electrode 250 and the resonance inducing layer 310, and an interface between the resonance inducing layer 310 and the thin film encapsulation layer 410. However, light may be reflected at one or more of these interlayer interfaces.

For example, light may be reflected at the interface between the resonance inducing layer 310 and the thin film encapsulation layer 410. Light reflected as such may be re-reflected at the interface between the second electrode 250 and the resonance inducing layer 310, or may travel to pass through the second electrode 250 and the organic light emitting layer 233 to be reflected at the interface between the first electrode 210 and the organic light emitting layer 233.

As such, light may be repeatedly reflected at each of the interfaces between the layers and the light may be subject to resonance due to the reflection. When such resonance occurs, the light may be amplified, whereby an amount of light emitted outwards is increased. With such a resonance effect, light emitted from the organic light emitting layer 233 may be efficiently amplified, such that light efficiency can be improved therein.

A reflectivity of light perpendicularly incident on an interface between a medium M1 having a refractive index of n1 and a medium M2 having a refractive index of n2 (refer to FIG. 3) may be obtained by Equation 1.

[Equation 1]

$$\text{Reflectivity} = (n2 - n1)^2/(n2 + n1)^2$$

In Equation 1, it may be appreciated that although factors determining the reflectivity are a sum of the refractive indices n1 and n2 and a difference therebetween for each layer, the difference between the refractive indices n1 and n2 may be a relatively significant factor therein. Accordingly, a reflectivity may increase as a difference between refractive indices of two layers forming an interface increases. Moreover, a possibility of resonance may increase in response to the increase in the reflectivity.

Meanwhile, frequent reflections at the interfaces may result in a light-path increase. For example, FIG. 3 illustrates light L1 propagating from the medium M2 toward the medium M1 without any reflection off an interface between the media M1 and M2, and light L2 propagating toward the medium M1 after being reflected at each interface of the medium M2 (i.e., two reflections). When a thickness of the medium M2 is "d" and an incident angle of light incident on the interface between the media M1 and M2 is "$\theta_2$," a light path of the light L2 incident on the medium M1 after being reflected off each interface of the medium M2 (i.e., two reflections) has a path difference of "2d/cosθ2" compared to a light path of the light L1 incident on the medium M1 without any reflection within the medium M2. When light incident on the medium M2 is reflected four times within the medium M2 and then incident on the medium M1, a path difference becomes "4d/cosθ2." Accordingly, as the number of times light is reflected increases, the path difference may be increased. Further, when the refractive index n1 of the medium M1 is less than the refractive index n2 of the medium M2, an incident angle $\theta_1$ at which light is incident on the medium M1 may become greater than the angle.

FIG. 4 illustrates a schematic view of a stacked structure for use in an OLED display device according to an exemplary embodiment. A repeated description pertaining to the internal structure of the OLED element 200 described above will be omitted, and the resonance inducing layer 310 and the thin film encapsulation layer 410 will be described hereinafter. In addition, light efficiency enhancement based on an optical distance between the organic light emitting layer 233 and the second electrode 250, i.e., an optical thickness (n*d), of an ETL will be described.

The OLED display device may have a multilayer structure, and in order to increase an intensity of light generated by the organic light emitting layer 233 and being emitted outwardly by passing through the multilayer structure, a resonance structure may be applied thereto. In a case in which optical resonance occurs during a period in which light is repeatedly reflected between the two reflective layers, intensity of light may increase, and such light having increased intensity may pass through the multilayer structure to be emitted outwardly. In addition, for efficient optical resonance, the layers constituting the OLED display device may have a predetermined thickness.

The OLED display device according to the exemplary embodiment may include the resonance inducing layer 310 disposed on the OLED element 200. The resonance inducing layer 310 may assist in efficient external emission of light generated in the organic light emitting layer 233.

The resonance inducing layer 310 may have a triple-layer structure in which the high-refractive-index layer 311, the first low-refractive-index layer 312, and the second low-refractive-index layer 313 are sequentially stacked.

In particular, an optical thickness of each of the layers constituting the resonance inducing layer 310 may be formed to be less than or equal to about λ/4 of a maximum wavelength, for example, about 780nm (7800 angstroms (Å)), of visible light, such that, in a case of an extremely great optical thickness, dispersion of energy to a wavelength band other than a wavelength band of visible light may be prevented. Accordingly, in particular, the high-refractive-index layer 311, the first low-refractive-index layer 312, and the second low-refractive-index layer 313 may have an optical thickness in a range of about 5 nm (50 Å) to about 150 nm (1500Å). The optical thickness is determined by multiplying a refractive index and a thickness of a material.

The high-refractive-index layer 311 may have a refractive index in a range of about 1.6 to about 3.0, and may include at least one of SiON, $SiN_x$, $ZnO_x$, $ZrO_x$, $TiO_x$ and the like.

The high-refractive-index layer 311 may be formed of at least one of inorganic materials and organic materials. Accordingly, the high-refractive-index layer 311 may include an inorganic layer or an organic layer, or may include an organic layer containing inorganic particles.

Such inorganic materials applicable to the high-refractive-index layer 311 may include, for example, zinc oxide, titanium oxide, zirconium oxide, niobium oxide, tantalum oxide, tin oxide, nickel oxide, silicon nitride, indium nitride, gallium nitride, and the like.

Such organic materials applicable to the high-refractive-index layer 311 may include, for example, poly (3,4-ethylenedioxythiophene) (PEDOT), 4,4'-bis [N- (3-methylphenyl)-N-phenylamino] biphenyl (TPD), 4,4',4"-tris [(3-methylphenyl) phenylamino] triphenylamine (m-MTDATA), 1,3,5-tris [N,N-bis (2-methylphenyl) amino]-benzene (o-MTDAB), 1,3,5-tris[N,N-bis (3-methylphenyl) amino] benzene (m-MTDAB), 1,3,5- tris [N,N-bis (4-methylphenyl) amino] benzene (p-MTDAB), 4,4'-bis [N,N-bis (3-methylphenyl)-amino] diphenylmethane (BPPM), 4,4'-dicarbazolyl-1,1'-biphenyl (CBP), 4,4',4"-tris (N-carbazole) triphenyl amine (TCTA), 2,2',2"- (1,3,5-benzene-tolyl) tris-[1-phenyl-1H-benzoimidazol] (TPBI), 3-(4-biphenylyl) -4-phenyl-5-t-butylphenyl-1,2,4-triazole (TAZ), and the like.

The first and second low-refractive-index layers 312 and 313 may have a refractive index of about 1.3 to about 1.6. The first and second low-refractive-index layers 312 and 313 may use at least one of LiF, Liq, aluminum(III) bis(2-methyl-8-quninolinato)-4-phenylphenolate (BAlq), and SiO$_x$.

The first and second low-refractive-index layers 312 and 313 may be formed of at least one of inorganic materials and organic materials. Accordingly, the first and second low-refractive-index layers 312 and 313 may include an inorganic layer or an organic layer, or may include an organic layer containing inorganic particles.

Such inorganic materials applicable to the first and second low-refractive-index layers 312 and 313 may include, for example, silicon oxide and magnesium fluoride.

Such organic materials applicable to the first and second low-refractive-index layers 312 and 313 may include, for example, acrylic, polyimide, polyamide, alq3[Tris(8-hydroxyquinolinato)aluminum], and the like.

However, inorganic materials or organic materials applicable to the high-refractive-index layer 311, the first low-refractive-index layer 312, and the second low-refractive-index layer 313 in the OLED display device according to the exemplary embodiment may not be limited to the above-description, and any suitable materials known to those skilled in the art may be utilized.

The high-refractive-index layer 311 may have a thickness of about 30 nm (300Å) to about 100 nm (1000Å). The first low-refractive-index layer 312 may have a thickness of about 5 nm (50Å) to about 30 nm (300Å). The second low-refractive-index layer 313 may have a thickness of about 5 nm (50Å) to about 150 nm (1500Å).

In detail, a thickness D1 of the high-refractive-index layer 311 may be greater than a thickness D2 of the first low-refractive-index layer 312, and a thickness D3 of the second low-refractive-index layer 313 may be greater than the thickness D2 of the first low-refractive-index layer 312.

The resonance inducing layer 310 may enhance light extraction efficiency by having a multilayer structure having different refractive indices and an asymmetrical structure in which the first and second low-refractive-index layers 312 and 313, on opposite sides of the high-refractive-index layer 311, have different thicknesses.

Referring to FIG. 4, the thin film encapsulation layer 410 may be disposed upwardly of the resonance inducing layer 310. Although the thin film encapsulation layer 410 is illustrated as having the triple-layer structure including the inorganic layer 411, the organic layer 412, and the inorganic layer 413, the thin film encapsulation layer 410 is not limited thereto in embodiments of the invention.

A refractive index of the thin film encapsulation layer 410 is not particularly limited in embodiments of the invention, and an optical thickness (refractive index*thickness) of each of the layers constituting the thin film encapsulation layer 410 may be greater than or equal to a wavelength of visible light, which is in a range of about 380 nm (3800Å) to about 780 nm (7800Å).

In addition to the aforementioned enhancement in light extraction efficiency by the resonance inducing layer 310, the OLED display device according to the exemplary embodiment may enhance light extraction efficiency by adjusting an optical distance between the organic light emitting layer 233 and the second electrode 250, i.e., an optical thickness of an ETL 235 within the internal structure of the OLED element 200.

Tables 1 through 3 represent simulation results of efficiency and an efficiency rate based on a thickness of the ETL when a thickness of the high-refractive-index layer 311 of the resonance inducing layer 310 is 40 nm (400Å), 50 nm (500Å), and 60 nm (600Å). Here, the efficiency and efficiency rate are obtained based on a calculation in which maximum efficiency is 100% when the thickness of the high-refractive-index layer 311 is 50 nm (500Å). FIG. 5A through 5C are graphs illustrating light extraction efficiency based on an optical thickness of an ETL.

[Table 1]

| High-Refractive-Index Layer (40 nm, 400Å) | | |
|---|---|---|
| ETL Optical Thickness (Å) | White Efficiency | White Efficiency Rate |
| 227.4 | 38.55 | 79% |
| 276.9 | 41.22 | 85% |
| 326.4 | 43.42 | 89% |
| 375.9 | 44.90 | 92% |
| 425.4 | 45.39 | 93% |

(continued)

| High-Refractive-Index Layer (40 nm, 400Å) | | |
|---|---|---|
| ETL Optical Thickness (Å) | White Efficiency | White Efficiency Rate |
| 474.9 | 44.96 | 93% |
| 524.4 | 43.74 | 90% |
| 573.9 | 41.68 | 86% |
| 623.4 | 39.15 | 81% |
| 672.9 | 36.64 | 75% |
| 722.4 | 34.40 | 71% |
| 771.9 | 32.62 | 67% |
| 821.4 | 31.44 | 65% |

[Table 2]

| High-Refractive-Index Layer (50 nm, 500Å) | | |
|---|---|---|
| ETL Optical Thickness (Å) | White Efficiency | White Efficiency Rate |
| 260 | 41.24 | 85% |
| 310 | 44.09 | 91% |
| 360 | 46.45 | 96% |
| 410 | 48.02 | 99% |
| 460 | 48.55 | 100% |
| 510 | 48.10 | 99% |
| 560 | 46.79 | 96% |
| 610 | 44.58 | 92% |
| 660 | 41.88 | 86% |
| 710 | 39.19 | 81% |
| 760 | 36.79 | 76% |
| 810 | 34.89 | 72% |
| 860 | 33.63 | 69% |

[Table 3]

| High-Refractive-Index Layer (60 nm, 600Å) | | |
|---|---|---|
| ETL Optical Thickness (Å) | White Efficiency | White Efficiency Rate |
| 272.4 | 40.00 | 82% |
| 321.9 | 42.76 | 88% |
| 371.4 | 45.05 | 93% |
| 420.9 | 46.58 | 96% |
| 470.4 | 47.09 | 97% |
| 519.9 | 46.65 | 96% |
| 569.4 | 45.38 | 93% |

(continued)

| High-Refractive-Index Layer (60 nm, 600Å) | | |
| --- | --- | --- |
| ETL Optical Thickness (Å) | White Efficiency | White Efficiency Rate |
| 618.9 | 43.24 | 89% |
| 668.4 | 40.62 | 84% |
| 717.9 | 38.01 | 78% |
| 767.4 | 35.68 | 73% |
| 816.9 | 33.84 | 70% |
| 866.4 | 32.62 | 67% |

Referring to Table 1 and FIG. 5A, when the thickness of the high-refractive-index layer 311 is 40 nm (400Å), an optical distance between the organic light emitting layer 233 and the second electrode 250, i.e., an optical thickness of the ETL 235, which may enhance light extraction efficiency may be in a range of about 33 nm (330Å) to about 53 nm (530Å).

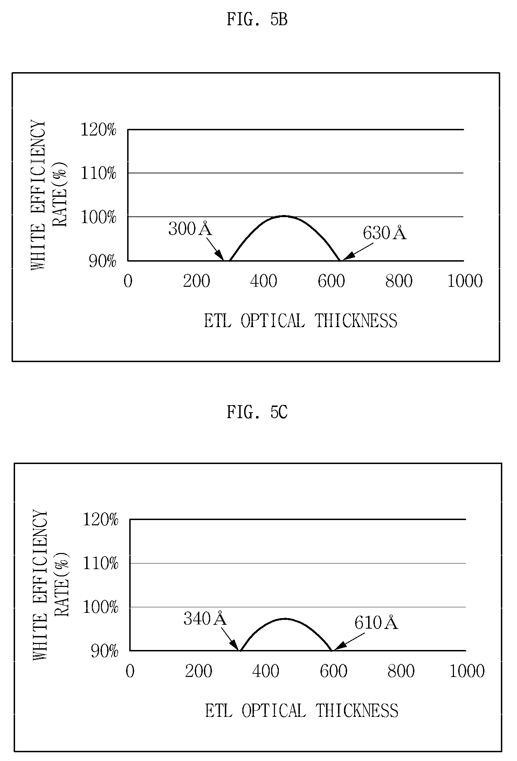

Referring to Table 2 and FIG. 5B, when the thickness of the high-refractive-index layer 311 is 50 nm (500Å), an optical distance between the organic light emitting layer 233 and the second electrode 250, i.e., an optical thickness of the ETL 235, which may enhance light extraction efficiency may be in a range of about 30 nm (300Å) to about 63 nm (630Å).

Referring to Table 3 and FIG. 5C, when the thickness of the high-refractive-index layer 311 is 60 nm (600Å), an optical distance between the organic light emitting layer 233 and the second electrode 250, i.e., an optical thickness of the ETL 235, which may enhance light extraction efficiency may be in a range of about 34 nm (340Å) to about 61 nm (610Å). Accordingly, in the OLED display device according to the exemplary embodiment, the optical distance between the organic light emitting layer 233 and the second electrode 250 may be in a range of about 30 nm (300Å) to about 63 nm (630Å). When the above conditions are satisfied, efficiency of light generated in the organic light emitting layer 233 being emitted outwardly of the OLED element 200 may increase to enhance light efficiency of the OLED display device.

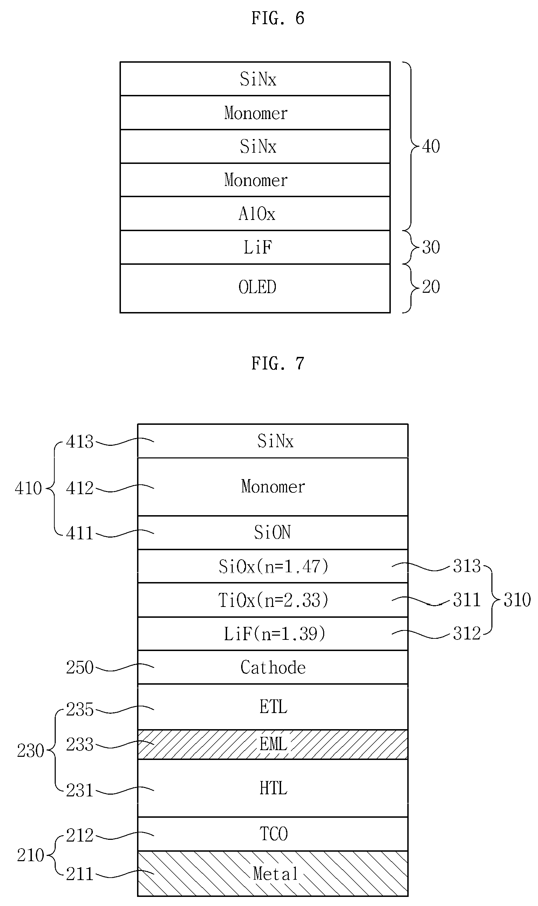

FIG. 7 illustrates a schematic view of an OLED display device according to Example 1.

An OLED display device according to Example 1 may include an OLED element 200. The OLED element 200 may include the first electrode 210 on the substrate 110, the light emitting element 230 on the first electrode 210, and the second electrode 250 on the light emitting element 230. The light emitting element 230 may include the organic light emitting layer 233 on the first electrode 210. In addition, the light emitting element 230 may include the HTL 231, between the first electrode 210 and the organic light emitting layer 233, and the ETL 235, between the organic light emitting layer 233 and the second electrode 250.

The first electrode 210 may be a reflective electrode including a reflective layer 211. In detail, the first electrode 210 may include the reflective layer 211 including one or more metals of Mg, Ag, Au, Ca, Li, Cr, copper (Cu), Al, and the like, and a transparent conductive layer 212 on the reflective layer 211.

The transparent conductive layer 212 may include TCO, for example, at least one of ITO, IZO, ZnO, aluminum zinc oxide (AZO), $In_2O_3$, and the like. The transparent conductive layer 212 may have a relatively high work function. When the first electrode 210 has the transparent conductive layer 212, hole injection through the first electrode 210 may be readily performed.

In addition, the first electrode 210 may have a triple-layer structure in which a transparent conductive layer, a reflective layer, and a transparent conductive layer are sequentially stacked.

The second electrode 250 may be formed of a transflective layer including one or more of Mg, Ag, Au, Ca, Li, Cr, Cu, Al, and the like.

Light generated in the organic light emitting layer 233 may pass through the second electrode 250, while a portion of the light may be reflected off a lower surface of the second electrode 250. An optical distance between the organic light emitting layer 233 and the second electrode 250, i.e., an optical thickness of the ETL 235 may be in a range of about 30 nm (300Å) to about 63 nm (630Å).

As illustrated in FIG. 7, the resonance inducing layer 310 disposed upwardly of the second electrode 250 may have a triple-layer structure in which the first low-refractive-index layer 312, the high-refractive-index layer 311, and the second low-refractive-index layer 313 are sequentially stacked. The resonance inducing layer 310 according to Example 1 may include the first low-refractive-index layer 312 (LiF) having a refractive index of 1.39 and a thickness of 10 nm (100Å), the high-refractive-index layer 311 ($TiO_x$) having a refractive index of 2.33 and a thickness of 50 nm (500Å), and the second low-refractive-index layer 313 ($SiO_x$) having a refractive index of 1.47 and a thickness of 70 nm (700Å).

The thin film encapsulation layer 410 may have a triple-layer structure in which the inorganic layer 411 of SiON having a thickness of 700 nm (7000Å), the organic layer 412 of a monomer having a thickness of 4000 nm (40000Å), and the inorganic layer 413 of $SiN_x$ having a thickness of 700 nm (7000Å) are sequentially stacked.

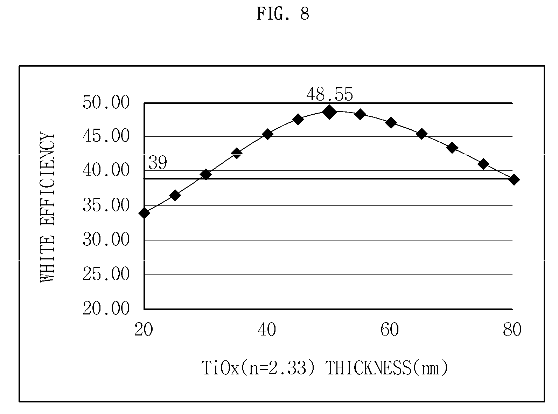

FIG. 8 illustrates a graph of light extraction efficiency of the OLED display device based on a thickness of $TiO_x$, i.e., the high-refractive-index layer 311 of the resonance inducing layer 310 according to Example 1.

An OLED display device according to Comparative Example 1 (refer to FIG. 6) may include a capping layer 30 formed as a single layer and a thin film encapsulation layer 40 formed of five layers, the capping layer 30 and thin film encapsulation layer 40 being on an OLED element 20. In particular, the capping layer 30 may be LiF. The five layers of the thin film encapsulation layer 40 may include $AlO_x$, monomer, $SiN_x$, monomer, and $SiN_x$, sequentially stacked.

Referring to FIG. 8, it may be appreciated that when the high-refractive-index layer 311 has a thickness of 500Å (50nm), Example 1 represents efficiency of 48.55, and is enhanced in light extraction efficiency by 24% as compared to that in Comparative Example 1 (efficiency of 39).

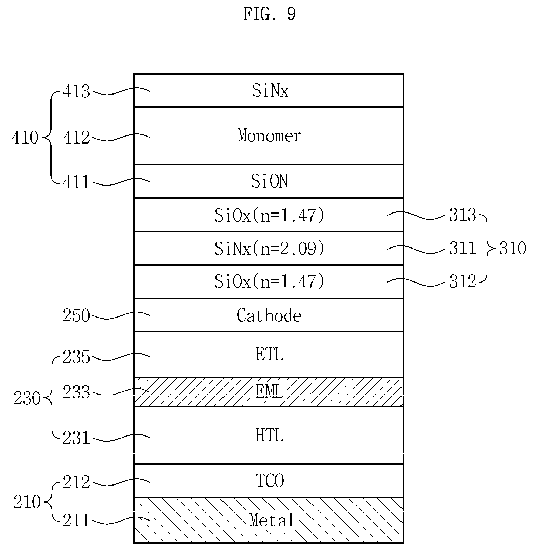

Hereinafter, Example 2 will be described with reference to FIG. 9. FIG. 9 illustrates a schematic view of an OLED display device according to Example 2.

Since the OLED display device according to Example 2 is the same as the OLED display device according to Example 1 (FIG. 7) aside from a resonance inducing layer 310, details pertaining to the same configuration thereof will be omitted for conciseness.

Referring to FIG. 9, the resonance inducing layer 310 may have a triple-layer structure in which the first low-refractive-index layer 312, the high-refractive-index layer 311, and the second low-refractive-index layer 313 are sequentially stacked. The resonance inducing layer 310 according to Example 2 may include the first low-refractive-index layer 312 ($SiO_x$) having a refractive index of 1.47 and a thickness of 150 nm (150Å), the high-refractive-index layer 311 ($SiN_x$) having a refractive index of 2.09 and a thickness of 50 nm (500Å), and the second low-refractive-index layer 313 ($SiO_x$) having a refractive index of 1.47 and a thickness off 70 nm (700Å).

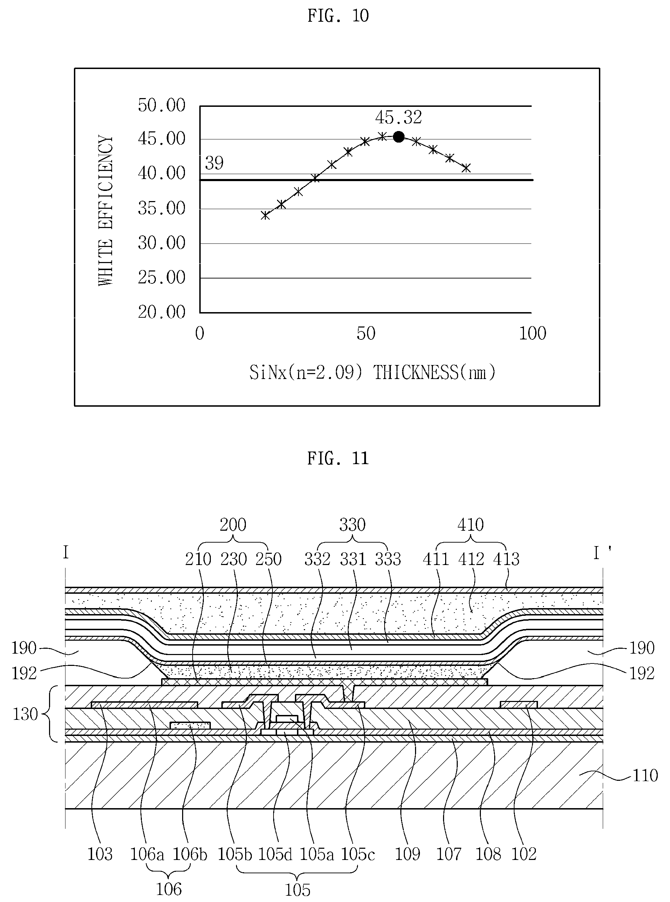

FIG. 10 illustrates a graph of light extraction efficiency of the OLED display device based on a thickness of $SiN_x$, that is, the high-refractive-index layer 311 of the resonance inducing layer 310 of Example 2.

As described above, the OLED display device according to Comparative Example 1 (refer to FIG. 6) may include the capping layer 30 formed as a single layer and the thin film encapsulation layer 40 formed of five layers, the capping layer 30 and thin film encapsulation layer 40 being formed on the OLED element 20.

Referring to FIG. 10, it may be appreciated that Example 2 represents efficiency of 45.15, and is enhanced in light extraction efficiency by 16% as compared to that in Comparative Example 1 (efficiency of 39).

FIG. 11 illustrates a cross-sectional view of an OLED display device according to another exemplary embodiment.

An OLED display device according to another exemplary embodiment may include the substrate 110; the first electrode 210 on the substrate 110; the light emitting layer 233 on the first electrode 210; the auxiliary light emitting layer 235 on the light emitting layer; the second electrode 250 on the auxiliary light emitting layer 235; and a resonance inducing layer 330 including a first high-refractive-index layer on the second electrode, a low-refractive-index layer on the first high-refractive-index layer, wherein the auxiliary light emitting layer has an optical distance in a range of about 30 nm (300Å) to about 63 nm (630Å), and the first high-refractive-index layer and the low-refractive-index layer of the resonance inducing layer have a thickness in a range of about 50 nm (50Å) to about 150 nm (1500Å).

Referring to FIG. 11, the OLED display device according to the other exemplary embodiment may include the first substrate 110, the drive circuit unit 130, the OLED element 200, the resonance inducing layer 330, and the thin film encapsulation layer 410. Since the OLED display device according to the other exemplary embodiment is the same as the OLED display device in FIG. 2, aside from a resonance inducing layer 330, details pertaining to the same configuration thereof will be omitted for conciseness.

The resonance inducing layer 330 may be on the second electrode 250, and may include a low-refractive-index layer 331, a first high-refractive-index layer 332, and a second high-refractive-index layer 333. The resonance inducing layer 330 may assist in efficient external emission of light generated in an organic light emitting layer 233.

In particular, an optical thickness of each of the layers constituting the resonance inducing layer 330 may be formed to be less than or equal to about $\lambda/4$ of a maximum wavelength, for example, about 780nm (7800Å), of visible light, such that in a case of an extremely great optical thickness, dispersion of energy to a wavelength band other than a wavelength band of visible light may be prevented. Accordingly, in particular, the low-refractive-index layer 331, the first high-refractive-index layer 332, and the second high-refractive-index layer 333 may be formed to have an optical thickness of less than or equal to about 150 nm (1500Å), that is, in a range of about 5 nm (50Å) to about 150 nm (1500Å). Here, the optical thickness may be determined by a multiplication of a refractive index and a thickness of a material.

The low-refractive-index layer 331 may use at least one of LiF, Liq, aluminum(III) bis(2-methyl-8-quninolinato)-4-phenylphenolate (BAlq), $SiO_x$, and the like. The low-refractive-index layer 331 may be formed of at least one of inorganic materials and organic materials. Accordingly, the low-refractive-index layer 331 may include an inorganic layer or an organic layer, or may include an organic layer containing inorganic particles.

Such inorganic materials applicable to the low-refractive-index layer 331 may include, for example, silicon oxide, magnesium fluoride, and the like.

Such organic materials applicable to the low-refractive-index layer 331 may include, for example, acrylic, polyimide, polyamide, and alq3[Tris(8-hydroxyquinolinato)aluminum], and the like.

The first and second high-refractive-index layers 332 and 333 may have a refractive index in a range of about 1.6 to about 3.0, and may include at least one of SiON, $SiN_x$, $ZnO_x$, $TiO_x$, and the like

The first and second high-refractive-index layers 332 and 333 may be formed of at least one of inorganic materials and organic materials. Accordingly, the first and second high-refractive-index layers 332 and 333 may include an inorganic layer or an organic layer, or may include an organic layer containing inorganic particles.

Such inorganic materials applicable to the first and second high-refractive-index layers 332 and 333 may include, for example, zinc oxide, titanium oxide, zirconium oxide, niobium oxide, tantalum oxide, tin oxide, nickel oxide, silicon nitride, indium nitride, gallium nitride, and the like.

Such organic materials applicable to the first and second high-refractive-index layers 332 and 333 may include, for example, poly (3,4-ethylenedioxythiophene) (PEDOT), 4,4'-bis [N- (3-methylphenyl)-N-phenylamino] biphenyl (TPD), 4,4',4"-tris [(3-methylphenyl) phenylamino] triphenylamine (m-MTDATA), 1,3,5-tris [N,N-bis (2-methylphenyl) amino]-benzene (o-MTDAB), 1,3,5-tris[N,N-bis (3-methylphenyl) amino] benzene (m-MTDAB), 1,3,5- tris [N,N-bis (4-methylphenyl) amino] benzene (p-MTDAB), 4,4'-bis [N,N-bis (3-methylphenyl)-amino] diphenylmethane (BPPM), 4,4'-dicarbazolyl-1,1'- biphenyl (CBP), 4,4',4"-tris (N-carbazole) triphenyl amine (TCTA), 2,2',2"-(1,3,5-benzene-tolyl) tris-[1-phenyl-1H-benzoimidazol] (TPBI), 3-(4-biphenylyl)-4-phenyl-5-t-butylphenyl-1,2,4-triazole (TAZ), and the like.

However, inorganic materials or organic materials applicable to the low-refractive-index layer 331, the first high-refractive-index layer 332, and the second high-refractive-index layer 333 according to the other exemplary embodiment may not be limited to the above-description, and any suitable materials known to those skilled in the art may be utilized.

The low-refractive-index layer 331 may have a thickness of about 5 nm (50Å) to about 100 nm (1000Å). The first high-refractive-index layer 332 may have a thickness of about 5 nm (50Å) to about 30 nm (300Å), and the second high-refractive-index layer 333 may have a thickness of about 5 nm (50Å) to about 150 nm (1500Å).

The resonance inducing layer 330 may enhance light extraction efficiency by having a multilayer structure having different refractive indices and an asymmetrical structure in which the first and second high-refractive-index layers 332 and 333, disposed on opposite sides of the low-refractive-index layer 331, have different thicknesses.

The OLED display device according to the other exemplary embodiment may be a top-emission type. Light generated in the organic light emitting layer 233 may be emitted outwardly through the second electrode 250, the resonance inducing layer 330, and the thin film encapsulation layer 410.

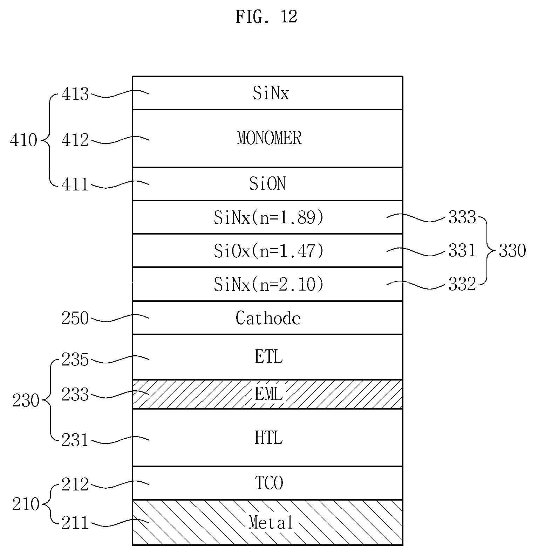

FIG. 12 illustrates a schematic view of an OLED display device according to Example 3.

Since the OLED display device according to Example 3 is the same as the OLED display device according to Example 1 (FIG. 7) aside from a resonance inducing layer 330, details pertaining to the same configuration thereof will be omitted for conciseness.

Referring to FIG. 12, the resonance inducing layer 330 may have a triple-layer structure in which the first high-refractive-index layer 332, the low-refractive-index layer 331, and the second high-refractive-index layer 333 are sequentially stacked. The resonance inducing layer 330 according to Example 3 may include the first high-refractive-index layer 332 ($SiN_x$) having a refractive index of 2.10 and a thickness of 70 nm (700Å), the low-refractive-index layer 331 ($SiO_x$) having a refractive index of 1.47 and a thickness of 90 nm (900Å), and the second high-refractive-index layer 333 ($SiN_x$) having a refractive index of 1.89 and a thickness of 80 nm (800Å).

Table 4 represents light extraction efficiency for each of RGB of Comparative Example 1 and Example 3.

The OLED display device according to Comparative Example 1 (refer to FIG. 6) may include the capping layer 30 formed as a single layer and the thin film encapsulation layer 40 formed of five layers, the capping layer 30 and thin film encapsulation layer 40 being formed on the OLED element 20.

[Table 4]

| | R | | | G | | | B | | | W Efficiency |
|---|---|---|---|---|---|---|---|---|---|---|
| | R_x | R_y | Efficiency | G_x | G_y | Efficiency | B_x | B_y | Efficiency | |
| Comp. Ex. | 0.66 2 | 0.337 | 46.5 | 0.23 6 | 0.710 | 105.9 | 0.139 | 0.051 | 5.29 | 39.01 |
| Ex. 3 | 0.66 1 | 0.338 | 52.8 | 0.24 0 | 0.715 | 119.5 | 0.137 | 0.052 | 5.94 | 43.27 |

Referring to Table 4, it may be appreciated that Example 3, in which the resonance inducing layer 330 has the triple-layer structure in which the first high-refractive-index layer 332, the low-refractive-index layer 331, and the second high-refractive-index layer 333 are sequentially stacked and an optical distance between the organic light emitting layer 233 and the second electrode 250, that is, an optical thickness of an ETL 235, is in a range of about 30 nm (300Å) to about 63 nm (630Å), represents efficiency of 43.27 and is enhanced in light extraction efficiency by 11% as compared to that in Comparative Example 1 (efficiency of 39.01).

As set forth above, according to exemplary embodiments, the OLED display device may enhance light efficiency.

As discussed, embodiments of the present invention can provide an organic light emitting diode, OLED, display device comprising: a substrate; a first electrode on the substrate; a light emitting layer on the first electrode; an auxiliary light emitting layer on the light emitting layer; a second electrode disposed on the auxiliary light emitting layer; and a resonance inducing layer on the second electrode, the resonance inducing layer including a first low-refractive-index layer and a first high-refractive-index layer, wherein the auxiliary light emitting layer has an optical distance in a range of about 30 nm to about 63 nm, and the first low-refractive-index layer and the first high-refractive-index layer of the resonance inducing layer each has a thickness in a range of about 5 nm to about 150 nm. The auxiliary light emitting layer may be an electron transporting layer.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

**Claims**

1.    An organic light emitting diode, OLED, display device comprising:

a substrate;
a first electrode on the substrate;
a light emitting layer on the first electrode;
an auxiliary light emitting layer on the light emitting layer;
a second electrode disposed on the auxiliary light emitting layer; and
a resonance inducing layer on the second electrode, the resonance inducing layer including a first low-refractive-index layer and a first high-refractive-index layer,
wherein the auxiliary light emitting layer has an optical distance in a range of about 30 nm to about 63 nm, and the first low-refractive-index layer and the first high-refractive-index layer of the resonance inducing layer each has a thickness in a range of about 5 nm to about 150 nm.

2.    The OLED display device as claimed in claim 1, wherein the auxiliary light emitting layer is an electron transporting layer, ETL,.

3.    The OLED display device as claimed in claim 1 or 2, wherein:

the first low-refractive-index layer is on the second electrode, and
the first high-refractive-index layer is on the first low-refractive-index layer;
optionally wherein the first high-refractive-index layer has a thickness greater than a thickness of the first low-refractive-index layer.

4.    The OLED display device as claimed in claim 3, wherein the resonance inducing layer further includes a second low-refractive-index layer on the first high-refractive-index layer.

5.    The OLED display device as claimed in claim 4, wherein the second low-refractive-index layer has a thickness different from a thickness of the first low-refractive-index layer;
optionally wherein the thickness of the second low-refractive-index layer is greater than the thickness of the first low-refractive-index layer.

6.    The OLED display device as claimed in claim 4 or 5, wherein:

the first low-refractive-index layer has a thickness in a range of about 5 nm to about 30 nm,
the first high-refractive-index layer has a thickness in a range of about 30 nm to about 100 nm, and

the second low-refractive-index layer has a thickness in a range of about 5 nm to 150 nm.

7. The OLED display device as claimed in any one of claims 4 to 6, wherein the first and second low-refractive-index layers have a refractive index in a range of about 1.3 to about 1.6, and the first high-refractive-index layer has a refractive index in a range of about 1.6 to about 3.0.

8. The OLED display device as claimed in any one of claims 4 to 7, wherein the first and second low-refractive-index layers include at least one of LiF, Liq, aluminum(III) bis(2-methyl-8-quninolinato)-4-phenylphenolate (BAlq), and $SiO_x$.

9. The OLED display device as claimed in any one of claims 1 to 8, wherein the first high-refractive-index layer includes at least one of SiON, $SiN_x$, $ZnO_x$, ZrOx, and $TiO_x$.

10. The OLED display device as claimed in claim 1 or 2, wherein:

the first high-refractive-index layer is on the second electrode, and
the first low-refractive-index layer is on the first high-refractive-index layer;
optionally wherein the first low-refractive-index layer has a thickness greater than a thickness of the first high-refractive-index layer.

11. The OLED display device as claimed in claim 10, wherein the resonance inducing layer further includes a second high-refractive-index layer on the first low-refractive-index layer;
optionally wherein:

the first high-refractive-index layer has a thickness in a range of about 5 nm to about 30 nm,
the first low-refractive-index layer has a thickness in a range of about 5 nm to about 100 nm, and
the second high-refractive-index layer has a thickness in a range of about 5 nm to about 150 nm.

12. The OLED display device as claimed in claim 11, wherein the first and second high-refractive-index layers have a refractive index in a range of about 1.6 to about 3.0, and the first low-refractive-index layer has a refractive index in a range of about 1.3 to about 1.6.

13. The OLED display device as claimed in any one of claims 10 to 12, wherein the low-refractive-index layer includes at least one of LiF, Liq, aluminum(III) bis(2-methyl-8-quninolinato)-4-phenylphenolate(BAlq), and $SiO_x$.

14. The OLED display device as claimed in any one of claims 11 to 13, wherein the first and second high-refractive-index layers include at least one of SiON, $SiN_x$, $ZnO_x$, $ZrO_x$, and $TiO_x$.

15. The OLED display device as claimed in any one of claims 1 to 14, further comprising an encapsulation layer on the resonance inducing layer, wherein the encapsulation layer has a structure in which an organic layer is disposed between a plurality of stacked inorganic layers, or a structure in which an inorganic layer and an organic layer are alternately stacked;
optionally wherein the inorganic layer includes at least one of $SiO_x$, SiON, and $SiN_x$, and the organic layer is a monomer.

FIG. 1

FIG. 2

FIG. 3

FIG. 4

| | |
|---|---|
| 413 | |
| 412 | 410 |
| 411 | |
| $D_3$ — 313 | |
| $D_1$ — 311 | 310 |
| $D_2$ — 312 | |
| 250 | |
| 235 | |
| 233 | 200 |
| 231 | |
| 210 | |

FIG. 5A

FIG. 5B

FIG. 5C

## FIG. 6

| | |
|---|---|
| SiNx | ⎫ |
| Monomer | |
| SiNx | ⎬ 40 |
| Monomer | |
| AlOx | ⎭ |
| LiF | ⎬ 30 |
| OLED | ⎬ 20 |

## FIG. 7

| | | |
|---|---|---|
| 413 — | SiNx | |
| 410 ⎰ 412 — | Monomer | ⎱ 410 |
| 411 — | SiON | |
| | SiOx(n=1.47) | — 313 ⎫ |
| | TiOx(n=2.33) | — 311 ⎬ 310 |
| | LiF(n=1.39) | — 312 ⎭ |
| 250 — | Cathode | |
| 235 — | ETL | |
| 230 ⎰ 233 — | EML | |
| 231 — | HTL | |
| 210 ⎰ 212 — | TCO | |
| 211 — | Metal | |

FIG. 8

FIG. 9

| | |
|---|---|
| 413 | SiNx |
| 410 { 412 | Monomer |
| 411 | SiON |
| | SiOx(n=1.47) — 313 |
| | SiNx(n=2.09) — 311 } 310 |
| | SiOx(n=1.47) — 312 |
| 250 | Cathode |
| 235 | ETL |
| 230 { 233 | EML |
| 231 | HTL |
| 212 | TCO |
| 210 { 211 | Metal |

FIG. 10

FIG. 11

FIG. 12

| | | |
|---|---|---|
| 413 | | SiNx |
| 410 { 412 | | MONOMER |
| 411 | | SiON |
| | SiNx(n=1.89) | 333 |
| | SiOx(n=1.47) | 331 } 330 |
| | SiNx(n=2.10) | 332 |
| 250 | | Cathode |
| 235 | | ETL |
| 230 { 233 | | EML |
| 231 | | HTL |
| 212 | | TCO |
| 210 { 211 | | Metal |

Europäisches
Patentamt

European
Patent Office

Office européen
des brevets

# EUROPEAN SEARCH REPORT

Application Number

EP 15 20 1429

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2014/041743 A1 (SONY CORP [JP]) 20 March 2014 (2014-03-20) * paragraphs [0021] - [0142]; figures 3-10 * | 1-15 | INV. H01L51/52 |
| A | US 2012/286255 A1 (TANAKA SHIN-YA [JP]) 15 November 2012 (2012-11-15) * paragraphs [0025] - [0062]; figures 1-3 * | 1-15 | |

TECHNICAL FIELDS SEARCHED (IPC)

H01L

The present search report has been drawn up for all claims

| Place of search | Date of completion of the search | Examiner |
|---|---|---|
| The Hague | 20 May 2016 | Boero, Mauro |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 3 041 061 A1**

## ANNEX TO THE EUROPEAN SEARCH REPORT
## ON EUROPEAN PATENT APPLICATION NO.

EP 15 20 1429

20-05-2016

| Patent document cited in search report | Publication date | Patent family member(s) | Publication date |
|---|---|---|---|
| WO 2014041743 A1 | 20-03-2014 | JP 2014056666 A<br>TW 201411833 A<br>WO 2014041743 A1 | 27-03-2014<br>16-03-2014<br>20-03-2014 |
| US 2012286255 A1 | 15-11-2012 | CN 102687593 A<br>EP 2521424 A1<br>JP 2011155002 A<br>KR 20120115340 A<br>TW 201131851 A<br>US 2012286255 A1<br>WO 2011081125 A1 | 19-09-2012<br>07-11-2012<br>11-08-2011<br>17-10-2012<br>16-09-2011<br>15-11-2012<br>07-07-2011 |

EPO FORM P0459

For more details about this annex : see Official Journal of the European Patent Office, No. 12/82